Europäisches Patentamt

European Patent Office

Office européen des brevets

(11) Publication number: **0 189 291**
**A2**

## EUROPEAN PATENT APPLICATION

(21) Application number: 86300321.6

(51) Int. Cl.⁴: **H 03 M 1/12**

(22) Date of filing: 17.01.86

(30) Priority: 23.01.85 US 693932

(43) Date of publication of application: 30.07.86
Bulletin 86/31

(84) Designated Contracting States: DE FR GB IT NL

(71) Applicant: TEKTRONIX, INC., Tektronix Industrial Park
D/S Y3-121 4900 S.W. Griffith Drive P.O. Box 500,
Beaverton Oregon 97077 (US)

(72) Inventor: Taylor, Stewart S., 16927 N.W. Hazelgrove
Court, Beaverton Oregon 97006 (US)

(74) Representative: Burke, Steven David et al, R.G.C.
Jenkins & Co. 12-15, Fetter Lane, London EC4A 1PL (GB)

(54) Method and system for enhancing the accuracy of analog-to-digital converters.

(57) A method and system for enhancing the accuracy of an
analog-to-digital converter. Calibration codes for each of a
plurality of possible output codes of an analog-to-digital con-
verter are stored in a memory at locations corresponding to
their respective converter output codes. The converter output
code is used to select a corresponding calibration code, which
may represent the system output code by itself, or may be con-
catonated with the converter output code to produce the
system output code. An ancillary circuit may be provided to
recalibrate the converter as needed.

METHOD AND SYSTEM FOR ENHANCING THE ACCURACY
OF ANALOG-TO-DIGITAL CONVERTERS

BACKGROUND OF THE INVENTION

This invention relates to analog-to-digital conversion methods and systems, and particularly to methods and systems for enhancing the accuracy of analog-to-digital converters.

It is more difficult to manufacture a high speed analog-to-digital converter ("ADC") having high accuracy than to manufacture a low speed ADC of comparable accuracy. However, there are applications where both high speed and high accuracy analog-to-digital conversion is needed.

The accuracy of an ADC is principally limited by equivalent input signal level offsets, produced by a variety of sources, that vary significantly with the input signal level of the ADC. This causes non-linearity in the ADC output code with respect to the input, that is, its transfer characteristic. Such offsets are typically caused by variations in component values, and the errors that they produce are typically measurable. While accuracy can be improved somewhat by modification during the testing and final manufacturing process, the amount of improvement that can be achieved by such modification is limited.

Such errors tend to exhibit long term stability, and even where they vary with temperature they tend to be stable over a period that greatly exceeds the conversion period of the ADC. Hence, in many applications the useful accuracy of an ADC could be improved by calibrating the output with a code having a higher number of bits, or elements, to specify more accurately the input level at which transitions occur.

In many cases it may be more practical and economical to provide ancillary circuitry to improve an ADC, rather than to modify the ADC itself. While others have previously employed ancilary circuitry to adjust the gain and overall offset of an ADC, such adjustments do not improve the linearity of the output. Accordingly, it would be desirable to provide a method and system employing circuitry ancillary to an ADC to improve its linearity, and thereby enhance its accuracy.

## SUMMARY OF THE INVENTION

The present invention is directed to a method for enhancing the accuracy of an analog-to-digital converter, and to a system for implementing that method employing ancillary calibration circuitry. The method is applicable to an ADC whose transfer function is monotonic and stable over a predetermined period of time, but whose absolute accuracy is less than desired. The enhancement is accomplished by observing the output of the ADC in response to a known input and storing a digital calibration code in a memory for each of the possible digital output codes of the ADC so that the calibration codes can be employed to produce a system output code having greater accuracy than the output code of the ADC itself.

In the simplest case, system output codes corresponding to each of the ADC output codes are stored in a memory. The output of the ADC addresses the location in the memory at which a corresponding system output code is stored, thereby causing the more accurate system output code to be read out of the memory and serve as the digital representation of the analog input to the ADC.

In a variant of the aforementioned approach the difference between the ADC output code and a more accurate digital representation of the input is stored in the memory in the form of the least significant bits of each system output code. The output from the ADC addresses the memory to select the least significant bits, which are thereafter concatonated with the ADC output code, comprising the most significant bits, to create the more accurate system output code.

In both of the preceding embodiments of the invention the calibration may occur at the time of manufacture of the ADC system, and the calibration data may be stored in read only memory. Alternatively, the system may be designed so that it is calibrated automatically as a result of turning on the system, or it may be calibrated periodically. This is accomplished by providing to the input of the ADC a plurality of values whose digital representations are known, or may be measured, to a desired accuracy, and storing calibration codes derived from those digital representations in a memory at addresses determined by and corresponding to the respective output codes of the ADC. This can be accomplished by the use of, for example, a ramp signal generator applied to the ADC, and a second ADC having significantly greater accuracy than the first ADC, but operating at a significantly slower speed. Where the first ADC exhibits long term stability it need be calibrated only when it is first turned on. Where the stability is short term, but nonetheless longer than the conversion time for a slower ADC, the calibration of the faster ADC may be periodically updated by the slower ADC.

Accordingly, it is a principal objective of the present invention to provide a method and system for enhancing the accuracy of an analog-to-digital converter.

It is another objective of the present invention to provide such a method and system which makes manufacture of a relatively accurate, high speed analog-to-digital conversion system easier.

It is a further objective of the present invention to provide a method and system for calibrating the output of an analog-to-digital converter to enhance its accuracy.

The foregoing and other objectives, features, and advantages of the invention will be more readily understood upon consideration of the following detailed description of the invention, taken in conjunction with the accompanying drawings.

## BRIEF DESCRIPTION OF THE DRAWINGS

FIG. 1(a) is an exemplary graph of a transfer function representative of a prior art ADC.

FIG. 1(b) is an exemplary graph of error of a prior art ADC as a function of input signal level.

FIG. 2 is a block diagram of a first embodiment of an ADC system according to the present invention.

FIG. 3(a) is an exemplary graph of the transfer function of an ADC system according to the present invention.

FIG. 3(b) is an exemplary graph of error of an ADC system according to the present invention as a function of input signal level.

FIG. 4(a) is an exemplary graph of a transfer function representative of an ADC having relatively good differential linearity but modest absolute accuracy.

FIG. 4(b) is an exemplary graph of error of an ADC of the type exemplified by FIG. 4(a) as a function of input signal level.

FIG. 4(c) is an exemplary graph of the transfer function of an ADC system according to the present invention as applied to an ADC of the type exemplified by FIG. 4(a).

FIG. 4(d) is an exemplary graph of error of an ADC system according to the present invention as applied to an ADC of the type exemplified by FIG. 4(a).

FIG. 5 is a block diagram of a second embodiment of an ADC system according to the present invention.

FIG. 6 is a block diagram of a third embodiment of an ADC system according to the present invention, including automatic calibration thereof.

DETAILED DESCRIPTION OF THE INVENTION

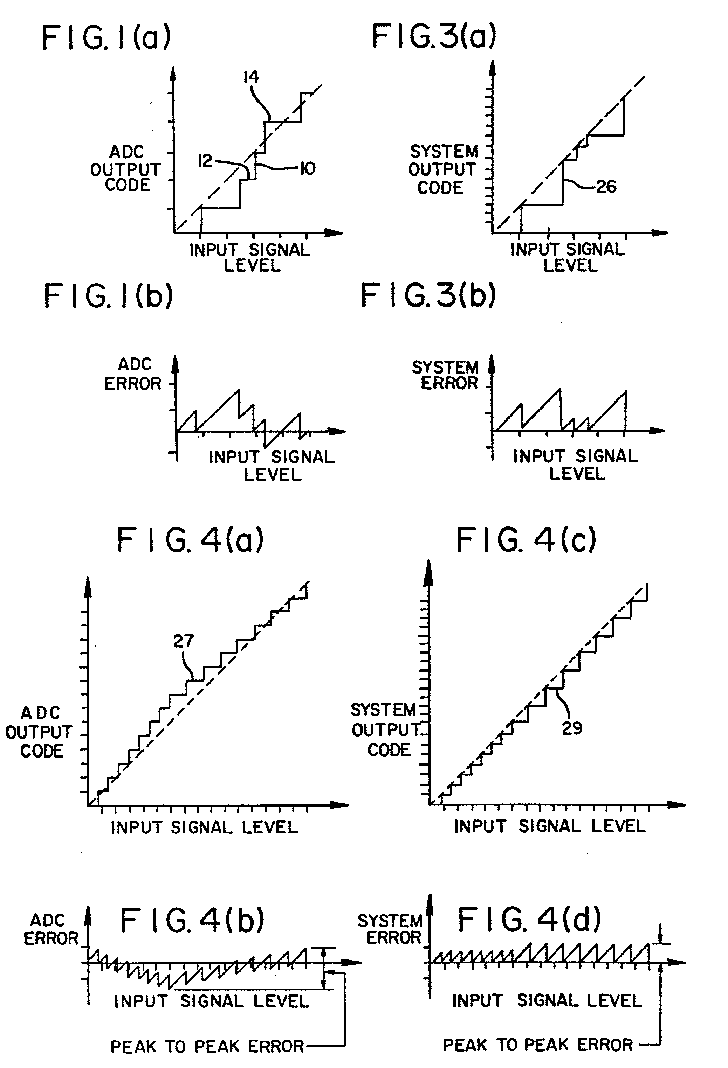

From the transfer function 10 of a typical prior art analog-to-digital converter, as shown in FIG. 1(a), it can be seen that the output code transitions of such an ADC do not correspond to uniform increments of the input signal level. While the ADC transfer function may be stable over a determinable period of time, so that the relationship between the input signal level and the output code is predictable and repeatable during that time period, the output code may represent an input value that is less than the actual input, as at 12, or greater than the actual input, as at 14. This produces output errors as shown by FIG. 1(b).

The present invention reduces output errors by calibrating the ADC output code so as to produce a system output code having a higher number of elements and corresponding to a value more nearly representative of the actual input signal level. Referring to FIG. 2, in the simplest case the enhancement system comprises an n-bit ADC 16, responsive to an input signal 18, which produces an n-bit output code 20. An encoder 22 receives the n-bit output code 20 and produces a corresponding system output code 24 that has $(n + m)$ bits, the m bits representing additional code elements. In the simplest case, the encoder 22 would comprise a memory employing one or more read-only memory ("ROM") or programmable read-only memory ("PROM") circuits and the n-bit code 20 would be employed to address a specific storage location within the memory circuits. The size of the memory would be $2^n \times (n + m)$ bits; that is, the n-bit input code could address any of $2^n$ storage locations, each of which would contain an $(n + m)$-bit calibration code.

In the case of an ADC whose transfer function is stable within the degree of accuracy desired, but whose output is inaccurate, the ADC 16 may be permanently calibrated at the time of manufacture by

-6-

comparing its output code 20 to a test input signal, generating an (n + m)-bit calibration code corresponding to a more accurate representation of the input signal, and storing the (n + m)-bit calibration code in the encoder 22 at an address corresponding to the n-bit code 20. This could be done, for example, by manufacturing the ADC 16 and the encoder 22, the latter in the form of a ROM, on the same wafer, and trimming the ROM to the correct calibration code.

As can be seen from FIG. 3(a), showing the transfer function 26 of the system shown in FIG. 2, the output of the ADC system has improved absolute accuracy; that is, the output code more nearly corresponds to the applied input level. As shown in FIG. 3(b) this results in reduced average error.

As shown by FIGS. 4(a)-(d), the invention is particularly well suited for enhancement of the accuracy of ADC's having good differential linearity but only modest absolute accuracy. This is because the invention will dramatically improve the absolute accuracy without significantly degrading the differential linearity. FIG. 4(a) exemplifies a transfer function 27 of an ADC having good differential linearity, that is, the input signal level increments that produce a change in the output code tend to be very nearly equal. As can be seen, however, this does not necessarily result in a transfer function whose steps fit a straight line. FIG. 4(b) shows the resultant error, which can be as significant as for an ADC having greater differential non-linearity. The steps of system transfer function 29, shown in FIG. 4(c), fit a straight line, and both the average and peak-to-peak error, as shown by FIG. 4(d), are less than they would be for an ADC having greater differential non-linearity.

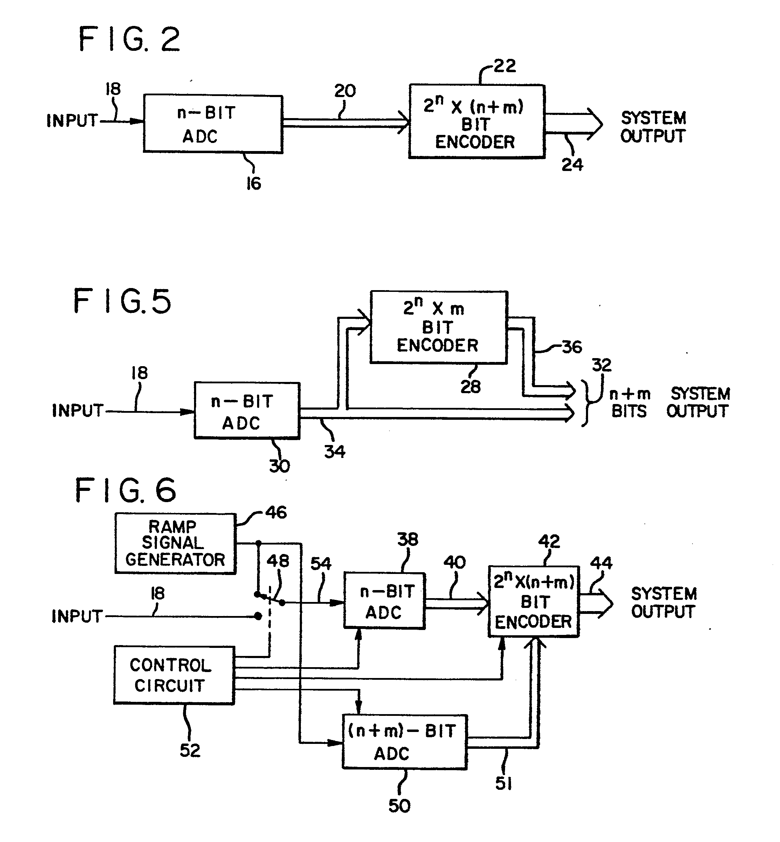

Turning now to FIG. 5, a variant of the embodiment shown in FIG. 2 employs an encoder 28 which only produces the least significant bits of a system output code. The system output code comprises the n-bit output code of an ADC 30, which forms the most significant bits of the output code, and an m-bit calibration code stored in the encoder 28, which forms the least significant bits of the output code. In this case the n-bit ADC 30 would be biased so that its output code could not exceed the actual input signal level. Similarly to the embodiment of FIG. 2, the n-bit output code 34 would be employed to address the storage locations in the encoder 28 to produce the m-bit calibration code 36. The n-bit output code 34 and the m-bit calibration code 36 would then be concatonated to produce an (n + m)-bit system output code 32.

In the case of an analog-to-digital converter whose transfer function changes over time or with temperature, a calibration circuit may be associated with the ADC. Where the transfer function simply varies each time the ADC is turned on, the ADC may be calibrated at turn on. Where the transfer function is stable only over a short period of time, the ADC may be calibrated periodically.

An embodiment of the invention which permits turn on or periodic calibration is shown in FIG. 6. The ADC 38 performs at relatively high speed, but modest accuracy. It produces an n-bit output code 40 which addresses an encoder 42 to produce an (n + m)-bit system output code 44 having a higher number of elements and greater accuracy. In order to calibrate the ADC, the system is provided with a ramp signal generator 46, an input switch 48, a relatively slow, but highly accurate (n + m)-bit ADC 50, and a control circuit 52. Upon command of the control circuit the switch connects the input 54 of the n-bit ADC 38 to the ramp signal generator, which is also connected to the input of the (n + m)-bit ADC 50. The (n + m)-bit ADC 50 is caused to produce an (n + m)-bit calibration code 51, which is stored in the encoder 42 at a location having an address corresponding to the n-bit output code 40 simultaneously produced by ADC 38. A plurality of such codes are produced as the ramp signal generator sweeps through the range of possible input signal levels. The design of appropriate circuitry to perform the functions shown in the block diagram of FIG. 5 is commonly known in the art.

Alternatively, an automatic calibration system as shown in FIG. 6 might employ a calibration scheme as shown in FIG. 5, and rather than a ramp signal generator and (n + m)-bit ADC, a counter and digital-to-analog converter might be employed to provide a known analog input signal level to the n-bit ADC 38 corresponding to an (n + m)-bit digital code produced by the counter. The digital code would be stored in the encoder as a calibration code at a storage location corresponding to the output code of the ADC whose accuracy is to be enhanced. Other calibration code generation circuits might also be employed without departing from the principles of the invention.

The terms and expressions which have been employed in the foregoing specification are used therein as terms of description and not of limitation, and there is no intention in the use of such terms and expressions of excluding equivalents of the features shown and described or portions thereof, it being recognized that the scope of the invention is defined and limited only by the claims which follow.

CLAIMS:

1. A method for enhancing the accuracy of an analog-to-digital converter, comprising the steps of:

    (a) observing the output code produced by said converter in response to an input signal, said converter output code having a first predetermined number of elements;

    (b) ascertaining a system output code having a second predetermined number of elements greater than said first predetermined number of elements, said system output code corresponding to said input signal level; and

    (c) producing, in response to said converter output code, said system output code.

2. The method of claim 1 wherein step (b) comprises for each of a plurality of possible converter output codes, storing in a memory a calibration code representative of a system output code that is a more accurate representation of a corresponding input signal level to said converter than the converter output code, and selecting a calibration code stored in said memory corresponding to the converter output code.

3. The method of claim 2, further comprising the steps of providing an input signal to said converter for which a digital code more accurately representative of the input signal level than the converter output code is known, and employing that digital code to produce said calibration code stored in said memory.

4.   The method of claim 3 wherein said calibration code is produced by subtracting the converter output code from the corresponding digital code and storing the difference in said memory at a location corresponding to said converter output code.

5.   The method of claim 3 wherein said calibration code is produced by storing the digital code in said memory at a location corresponding to said converter output code.

6.   The method of claim 3, further comprising periodically storing new sets of calibration codes in said memory based upon the application of a plurality of input signal levels having known corresponding digital codes.

7.   The method of claim 3, further comprising applying a known input signal level to said converter and producing a more accurate digital code by also applying said input signal level to a second, more accurate analog-to-digital converter.

8.   The method of claim 3, further comprising applying said digital code to a digital-to-analog converter and applying the output of said digital-to-analog converter to the input of said analog-to-digital converter, and storing said digital code in said memory at a location corresponding to the resultant converter output code.

9.   The method of claim 2 wherein said system output code is produced by concatonating the converter output code to said corresponding calibration code.

10. The method of claim 2 wherein said system output code is the same as said calibration code.

11. An analog-to-digital converter system, comprising:

(a) first analog-to-digital converter means for producing a distinct converter output code for a given input signal level, said converter output code having a first predetermined number of elements;

(b) encoder means for ascertaining a system output code having a second predetermined number of elements greater than said first predetermined number of elements, said system output code corresponding to said input signal level; and

(c) system output means for producing, in response to said converter output code, said system output code.

12. The system of claim 11 wherein said encoder means includes memory means for storing therein a calibration code representative of a system output code that is a more accurate representation of a corresponding input signal level to said first converter means than the corresponding converter output code.

13. The system of claim 12 wherein said memory means comprises a random-access memory and said system output means comprises means for addressing said random-access memory based upon said converter output code and means for concatonating the converter output code to the output of said random-access memory.

14. The system of claim 12 wherein said memory means comprises a random-access memory and said system output means comprises addressing means for selecting a storage location in said memory means based upon said converter output code.

15. The system of claim 12, further comprising signal generator means for supplying to said first converter means in sequence a plurality of known analog input signal levels, storage means for simultaneously supplying to said memory means a corresponding calibration code, and control means for causing said calibration code to be stored in said memory means at a storage location corresponding to the converter output code.

16. The system of claim 15 wherein said signal generator means comprises an analog signal generator and said storage means comprises a second analog-to-digital converter means having an output more accurate than the output of said first converter means and responsive to the output of said analog signal generator for producing an encoded representation of its output.

17. The system of claim 15 wherein said storage means comprises a digital code generator and said signal generator means comprises a digital-to-analog converter means responsive to said digital code generator for producing an analog signal having a level corresponding to the code produced by said digital code generator.

1/2                                    0189291

## FIG. 1(a)

ADC OUTPUT CODE vs INPUT SIGNAL LEVEL (labels 14, 12, 10)

## FIG. 3(a)

SYSTEM OUTPUT CODE vs INPUT SIGNAL LEVEL (label 26)

## FIG. 1(b)

ADC ERROR vs INPUT SIGNAL LEVEL

## FIG. 3(b)

SYSTEM ERROR vs INPUT SIGNAL LEVEL

## FIG. 4(a)

ADC OUTPUT CODE vs INPUT SIGNAL LEVEL (label 27)

## FIG. 4(c)

SYSTEM OUTPUT CODE vs INPUT SIGNAL LEVEL (label 29)

## FIG. 4(b)

ADC ERROR vs INPUT SIGNAL LEVEL

PEAK TO PEAK ERROR

## FIG. 4(d)

SYSTEM ERROR vs INPUT SIGNAL LEVEL

PEAK TO PEAK ERROR

FIG. 2

INPUT $\xrightarrow{18}$ | n−BIT ADC | $\xrightarrow{20}$ | $2^n \times (n+m)$ BIT ENCODER | $\rightarrow$ SYSTEM OUTPUT

16

22

24

FIG. 5

INPUT $\xrightarrow{18}$ | n−BIT ADC | → $2^n \times m$ BIT ENCODER

$\left.\begin{array}{c}\end{array}\right\}$ n+m BITS SYSTEM OUTPUT

30

34

28

36

32

FIG. 6

RAMP SIGNAL GENERATOR — 46

INPUT $\xrightarrow{18}$

48

54

n−BIT ADC — 38

40

$2^n \times (n+m)$ BIT ENCODER — 42

44 → SYSTEM OUTPUT

CONTROL CIRCUIT — 52

(n+m)−BIT ADC — 50

51